# FASCICULE DE BREVET EUROPEEN

(11) **EP 0 673 192 B1**
(45) Date de publication et mention de la délivrance du brevet: **12.11.1997**
(21) Numéro de dépôt: 95400544.3
(22) Date de dépôt: 14.03.1995
(51) Int. Cl.: H05K 7/14

(54) **Dispositif de support mécanique et d'interconnexions électriques**
Mechanische Trag- und elektrische Verbindungsvorrichtung
Device for mechanical support and for electrical interconnections

(30) Priorité: 15.03.1994 FR 9402978
(43) Date de publication de la demande: 20.09.1995
(73) Titulaire: THOMSON-CSF, 75008 Paris (FR)
(72) Inventeur: Bonniau, Philippe, F-92402 Courbevoie Cédex (FR); Chazelas, Jean, F-92402 Courbevoie Cédex (FR); Dumont, Bernard, F-92402 Courbevoie Cédex (FR); Proponet, Christian, F-92402 Courbevoie Cédex (FR)
(74) Mandataire: Benoit, Monique

(56) Documents cités:
- EP-A- 0 200 597
- DE-A- 2 320 202
- US-A- 4 758 459
- US-A- 4 922 059
- US-A- 5 259 784
- ELECTRONICS., vol. 58, no. 4, Janvier 1985 NEW YORK US, pages 51-54, GEORGE LAWRENCE 'Connectors boost system'
- PATENT ABSTRACTS OF JAPAN vol. 16 no. 210 (E-1203) ,19 Mai 1992 & JP-A-04 035084 (HITACHI CHEM. CO. LTD) 5 Février 1992,

## Description

La présente invention conceme un dispositif de support mécanique et d'interconnexions électriques. Elle s'applique notamment à la réalisation de systèmes électriques complexes disposant d'un encombrement réduit.

Certains systèmes électroniques complexes, à base de microprocesseurs notamment comportant des bus de données d'adresse et de contrôle pourvus d'un grand nombre de bits nécessitent des interconnexions de plus en plus denses. Ces interconnexions relient généralement entre elles des cartes ou des composants sur lesquels sont réparties les fonctions électroniques, au moyen d'une carte mère et de connecteurs, ces derniers reliant les cartes, dites cartes filles, à la carte mère. La carte mère comporte un réseau de pistes,réparties par exemple sur plusieurs couches, reliant les connecteurs entre eux. Dans le cas de systèmes électroniques complexes, étant donné le grand nombre de points à relier, le volume occupé par les interconnexions, c'est-à-dire notamment par la carte mère et les connecteurs, occupe une place de plus en plus importante. Les connecteurs actuels ayant atteint les limites de fiabilités relativement à leur taille, ce volume est par ailleurs incompressible. Cette évolution s'oppose à une réduction de volume et de poids de ces systèmes électroniques. La multiplicité des connecteurs tend par ailleurs à diminuer la fiabilité de l'ensemble. Un brevet US 4 758 459 décrit un circuit imprimé moulé en trois dimensions.

Le but de l'invention est de pallier ces inconvénients. Elle permet notamment de réduire le volume et le poids des systèmes d'interconnexions des matériels électroniques.

A cet effet, l'invention à pour objet un dispositif tel que décrit par la revendication 1.

L'invention a pour principaux avantages qu'elle améliore la fiabilité des interconnexions, qu'elle simplifie leur mise en oeuvre, qu'elle améliore la qualité des signaux, qu'elle permet une augmentation de la densité des interconnexions, et qu'elle est économique.

D'autres caractéristiques et avantages de l'invention apparaîtront à l'aide de la description qui suit faite en regard de dessins annexés qui représentent :
- la figure 1a, un système d'interconnexion selon l'art antérieur;

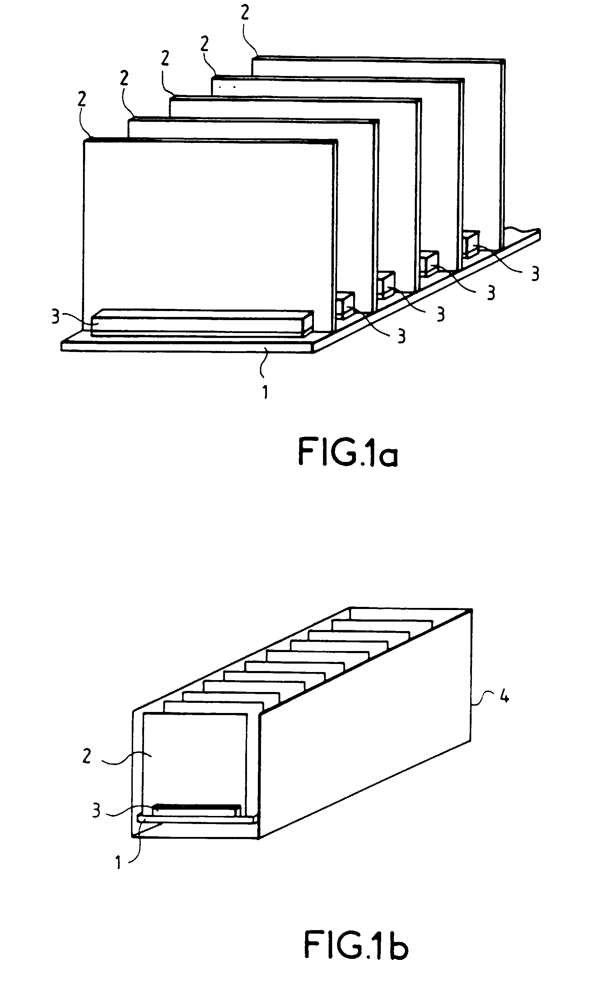

- la figure 1b, un système d'interconnexion fixé sur un support mécanique selon l'art antérieur ;
- les figures 2a et 2b, un mode de réalisation possible d'un dispositif selon l'invention ;
- les figures 3, 4 et 5, des modes de réalisation possibles de moyens d'interconnexion pour la mise en oeuvre d'un dispositif selon l'invention ;
- la figure 6, un mode de réalisation possible d'un dispositif selon l'invention muni de connecteurs principaux permettant une connexion avec d'autres systèmes électroniques.

Les figures la et 1b présentent un système d'interconnexions et un support mécanique classique. Une carte mère 1 supporte par exemple plusieurs cartes filles 2 reliées à celle-ci par des connecteurs 3. Une ou plusieurs fonctions électroniques sont par exemple réparties sur les cartes filles 2. Les échanges de signaux se font par l'intermédiaire des connecteurs 3 et de la carte mère 1. L'ensemble constitué de la carte mère 1, des connecteurs 3 et des cartes filles sont fixées dans un support mécanique 4. Cet ensemble doit notamment supporter certaines contraintes vibratoires ou de chocs mécaniques.

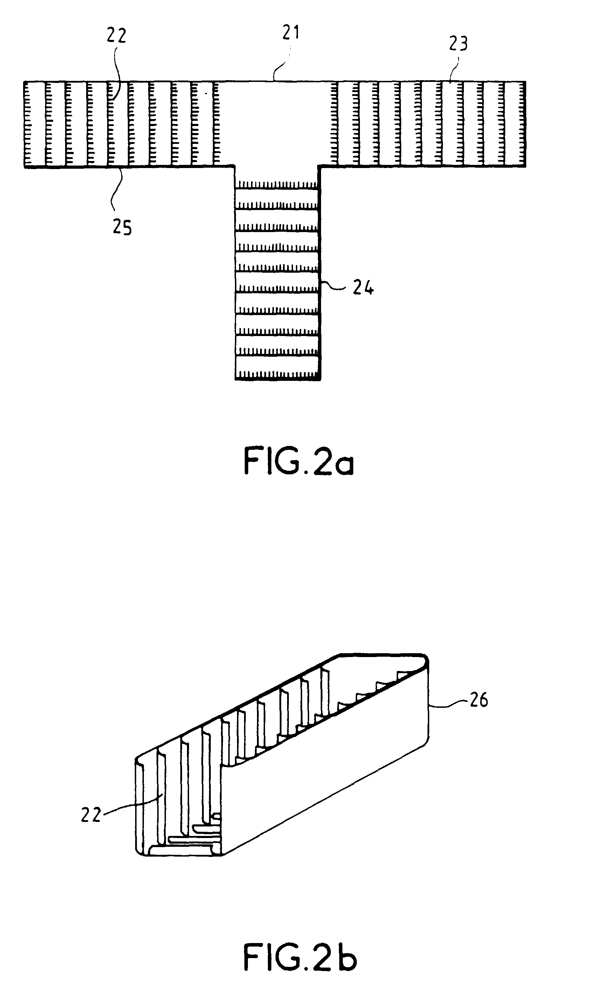

Les figures 2a et 2b présentent un mode de réalisation possible d'un dispositif selon l'invention. La figure 2a présente un circuit imprimé 21 développé constitué par exemple de plusieurs couches. Chaque couche comprend des lignes électriques reliées à des moyens de connexion 22. Les couches sont par exemple des feuilles en matière thermoplastique. Le circuit imprimé 21 tel que développé en figure 2a comprend par exemple trois parties 23, 24, 25 qui repliées peuvent former un coffret 26 comme l'illustre la figure 2b. Pour cela, le circuit imprimé de la figure 2a, à l'état développé, notamment ses feuilles thermoplastiques le constituant, est par exemple préformé suivant une forme désirée, celle du coffret 26 par exemple, puis chauffé. Après la phase de chauffage, le circuit imprimé devient rigide et conserve la forme qui lui a été assignée. Le circuit imprimé obtenu muni de ses moyens de connexion peut ainsi par exemple jouer le rôle de support mécanique des cartes filles qu'il contient, en tant que coffret, et le rôle de carte mère du système d'interconnexion. Un gain de volume du système d'interconnexions est ainsi obtenu, puisque d'une part le circuit imprimé joue à la fois le rôle de support mécanique et le rôle de carte mère, et d'autre part il est possible de prévoir non seulement des connexions sur un seul des côtés d'une carte fille, mais sur plusieurs, trois par exemple.

Dans l'exemple de réalisation des figures 2a et 2b, la forme du circuit imprimé rigidifié est celle d'un coffret classique. Cependant d'autres formes sont envisageables, notamment des formes qui permettent d'assurer un support mécanique des cartes filles résistant par exemple à un régime vibratoire ou de chocs thermiques. Pour cela, le circuit imprimé rigidifié comprend plusieurs parties orientées différemment dans l'espace pour assurer la tenue mécanique des cartes filles. Cela peut permettre en outre de prévoir des connexions sur au moins deux des côtés des cartes filles, et plus généralement de permettre des connexions sur le périmètre de ces dernières.

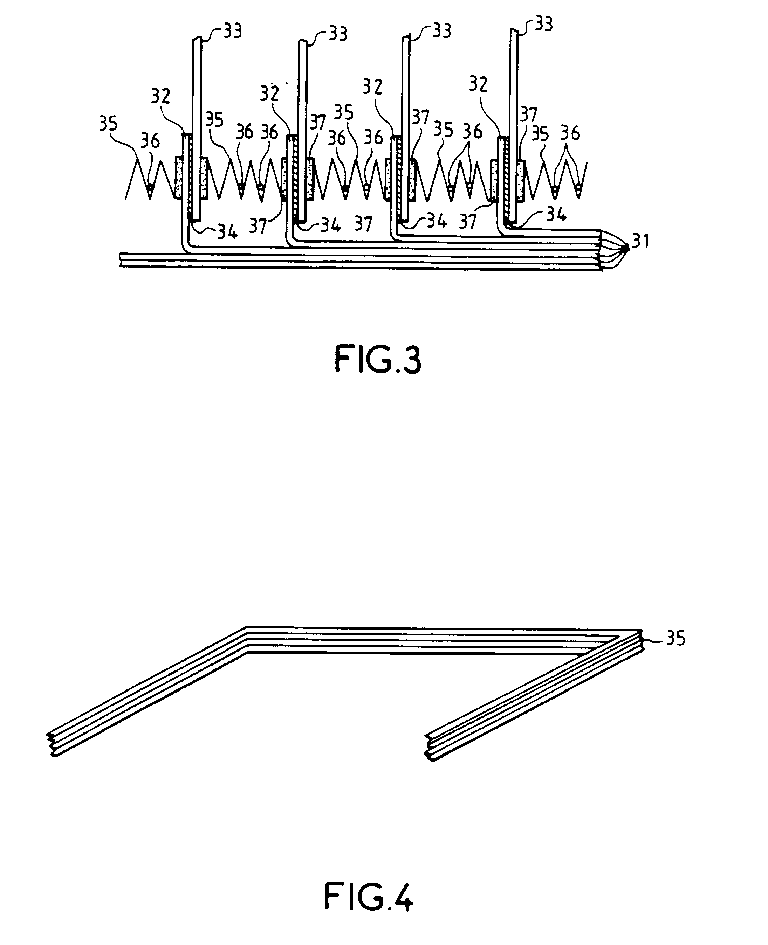

La figure 3 illustre un mode de réalisation possible des moyens de connexion 22 entre la carte mère et les cartes filles dans le cas d'un dispositif selon l'invention, ce mode de réalisation permet notamment d'améliorer la fiabilité des interconnexions.

La figure 3 représente en coupe une partie 23, 24, 25 du circuit imprimé rigide constituant à la fois la carte mère et le support mécanique. La carte mère ou le circuit imprimé est constituée de plusieurs couches 31, chaque couche comportant des lignes électriques d'interconnexion. Une partie terminale 32 de chaque couche 31 est relevée, c'est à dire par exemple pliée, puis rigidifiée, à 90 degrés par exemple par rapport à la couche. Les bords des cartes filles 33 peuvent alors être positionné face à ces parties pliées 32. Un élastomère conducteur 34 placé entre chaque partie pliée 32 des couches 31 et une carte fille 33 assure un contact électrique entre cette dernière et la carte mère ainsi qu'un contact mécanique élastique entre la carte fille 33 et la partie pliée 32. Ce contact mécanique permet notamment de maintenir les deux parties en contact par pression. Cette pression est par exemple assurée par des moyens constitués d'un ressort en alliage à mémoire de forme 35 ou tout autre type de système à ressort situé entre une carte fille 33 et la partie pliée 32 de la couche 31 reliée à sa carte voisine 33. Un ou plusieurs fils chauffants 36 sont par exemple situés à l'intérieur ou sur le pourtour de chaque ressort à mémoire de forme 35. Cela permet notamment de retirer une carte fille 33 du support mécanique 31 constituant la carte mère. En effet, en chauffant le ressort à mémoire de forme 35, celui-ci se rétracte, ce qui libère la carte fille 33. Des isolants thermiques 37 permettent d'isoler thermiquement les cartes filles 33 des ressorts à mémoire de forme 35. Des entretoises peuvent être disposés parallèlement aux ressorts 35 de façon à ce que lorsqu'une carte fille est retirée, cela ne déstabilise pas la position des autres cartes filles.

La figure 4 présente la forme d'un ressort à mémoire de forme 35 placé entre deux cartes filles. Ce ressort 35 a par exemple la forme globale d'un U afin de s'adapter à un support mécanique 26 du type de la figure 2b.

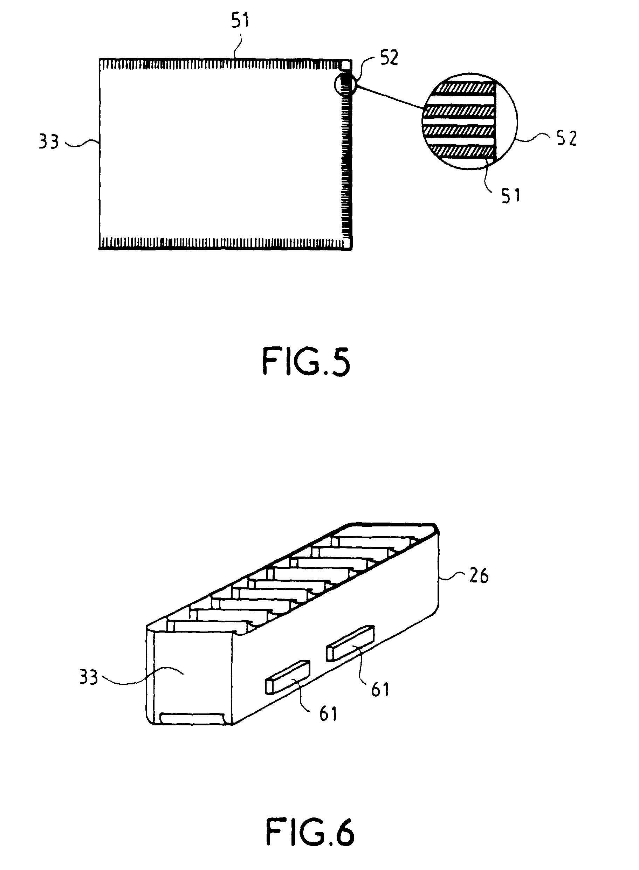

La figure 5 présente une carte fille 33, s'associant par exemple au ressort de la figure 4 pour être placée dans un support mécanique 26 du type de la figure 2b et faisant office de carte mère. La carte fille 33 a par exemple trois de ses quatre côtés dont les bords contiennent des pistes de connexion 51 illustrées par un agrandissement 52. Ces pistes 51 sont par exemple en regard des élastomères 34 présentés en figure 3 de façon à permettre un échange de signaux électriques entre une carte fille 33 et les couches 31 de la carte mère 26. L'élastomère 34 est réalisé de façon à ce que chacun de ses conducteurs élémentaires rencontre à la fois une piste 51 de la carte fille 33 sur laquelle il est en contact et une ou plusieurs lignes électriques de connexions de la carte mère 26.

Des connecteurs principaux d'entrée/sortie 61 peuvent être fixés sur la structure 26 comme l'illustre la figure 6 pour que cette structure puisse être par exemple reliée à un ou plusieurs autres systèmes électroniques.

Le dispositif selon l'invention peut être utilisé non seulement dans des systèmes électroniques complexes tels que des calculateurs ou circuits de traitement numérique mais aussi par exemple dans des systèmes nécessitant à la fois une grande densité d'interconnexion et un faible coût, tels que par exemple des téléphones portables ou des matériels d'électronique automobile.

L'invention permet d'améliorer la qualité des signaux échangés entre les cartes, car elle permet notamment une réalisation plus compacte de l'ensemble d'interconnexion.

Enfin, elle permet de diminuer, outre l'encombrement et le poids des systèmes d'interconnexion, leurs coûts puisque la carte mère joue aussi notamment le rôle de support mécanique.

## Revendications

1. Dispositif de support mécanique et d'interconnexions électriques constitué au moins d'un circuit imprimé rigide (26) préformé selon une forme donnée ayant plusieurs parties (22, 23, 24) orientées différemment dans l'espace et muni de moyens de connexions (22), caractérisé en ce que le circuit imprimé étant composé de plusieurs couches (31), les moyens de connexions (22) sont constitués au moins de parties terminales pliées (32) des couches et d'élastomères conducteurs (34), un élastomère permettant la liaison électrique entre le circuit imprimé et une carte (33), la liaison mécanique entre le circuit imprimé, l'élastomère (34) et la carte (33) étant assurée par pression.

2. Dispositif selon la revendication 1, caractérisé en ce qu'il fait office de carte mère connectée à des cartes filles (33) sur lesquelles sont réparties une ou plusieurs fonctions électroniques.

3. Dispositif selon l'une quelconque des revendications précédentes, caractérisé en ce qu'il constitue un coffret (26).

4. Dispostifif selon l'une quelconques des revendications précédentes, caractérisé en ce que la pression est assurée par un alliage à mémoire de forme (35) situé entre une carte (33) et la partie pliée (32) de la couche (31) reliée à sa carte voisine (33).

5. Dispositif selon la revendication 4, caractérisé en ce que l'alliage à mémoire de forme (35) est parcouru par un fil chauffant (36).

6. Dispositif selon la revendication 5, caractérisé en ce que le fil (36) est chauffé pour rétracter l'alliage à mémoire de forme (35) et permettre l'extraction de la carte (33) qu'il maintient.

7. Dispositif selon les revendications 5 et 6, caractérisé en ce qu'un isolant thermique (37) est situé entre l'alliage à mémoire de forme (35) et une carte (33) ou une partie pliée (32) d'une couche (31).

8. Dispositif selon l'une quelconque des revendications précédentes, caractérisé en ce que les cartes reliées au circuit imprimé ont des moyens de connexion répartis sur leur périmètre.

9. Dispositif selon l'une quelconque des revendications précédentes, caractérisé en ce qu'au moins un connecteur principal (61) fixé sur le circuit imprimé permet une connexion avec d'autres systèmes électroniques.

## Patentansprüche

1. Mechanische Halte- und elektrische Verbindungsvorrichtung, die aus mindestens einer steifen Druckschaltung (26) besteht, die gemäß einer gegebenen Form vorgeformt ist und mehrere Bereiche (22, 23, 24) aufweist, die unterschiedliche Ausrichtungen im Raum aufweisen, und mit Anschlußmitteln (22) versehen ist, dadurch gekennzeichnet, daß die Druckschaltung aus mehreren Schichten (31) besteht und die Anschlußmittel (22) zumindest aus gefalteten Endbereichen (32) der Schichten und leitenden Elastomerteilen (34) bestehen, wobei ein Elastomerteil die elektrische Verbindung zwischen der Druckschaltung und einer Karte (33) ermöglicht und wobei die mechanische Verbindung zwischen der Druckschaltung, dem Elastomerteil (34) und der Karte (33) durch Druck gewährleistet wird.

2. Vorrichtung nach Anspruch 1, dadurch gekennzeichnet, daß sie als Mutterkarte dient, die mit Tochterkarten (33) verbunden ist, auf denen eine oder mehrere elektronische Funktionen verteilt sind.

3. Vorrichtung nach einem beliebigen der vorhergehenden Ansprüche, dadurch gekennzeichnet, daß sie einen Kasten (26) bildet.

4. Vorrichtung nach einem beliebigen der vorhergehenden Ansprüche, dadurch gekennzeichnet, daß der Druck von einer Legierung (35) mit Formgedächtnis gewährleistet wird, die zwischen einer Karte (33) und dem umgefalteten Bereich (32) der Schicht (31) angeordnet ist, die mit der Nachbarkarte (33) verbunden ist.

5. Vorrichtung nach Anspruch 4, dadurch gekennzeichnet, daß die Legierung (35) mit Formgedächtnis von einem Heizdraht (36) durchlaufen wird.

6. Vorrichtung nach Anspruch 5, dadurch gekennzeichnet, daß der Draht (36) erwärmt wird, um die Legierung (35) mit Formgedächtnis zusammenzuziehen und die Entnahme der von ihr gehaltenen Karte (33) zu ermöglichen.

7. Vorrichtung nach den Ansprüchen 5 und 6, dadurch gekennzeichnet, daß ein Wärmeisolator (37) zwischen der Legierung (35) mit Formgedächtnis und einer Karte (33) oder einem umgefalteten Bereich (32) einer Schicht (31) liegt.

8. Vorrichtung nach einem beliebigen der vorhergehenden Ansprüche, dadurch gekennzeichnet, daß die an die Druckschaltung angeschlossenen Karten über ihren Umfang verteilte Anschlußmittel aufweisen.

9. Vorrichtung nach einem beliebigen der vorhergehenden Ansprüche, dadurch gekennzeichnet, daß mindestens ein Hauptsteckverbinder (51) an der Druckschaltung befestigt ist und eine Verbindung mit anderen elektronischen Systemen erlaubt.

## Claims

1. Electrical interconnections and mechanical support device consisting of at least one rigid printed circuit (26) preshaped in a given shape having several parts (22, 23, 24) oriented differently in space and is furnished with connection means (22), characterized in that, since the printed circuit is composed of several layers (31), the connection means (22) consist at least of folded terminal parts (32) of the layers and of conductor elastomers (34), an elastomer allowing electrical linkage between the printed circuit and a card (33), the mechanical linkage between the printed circuit, the elastomer (34) and the card (33) being afforded by pressure.

2. Device according to Claim 1, characterized in that it serves as a mother card connected to daughter cards (33) over which one or more electronic functions are distributed.

3. Device according to either one of the preceding claims, characterized in that it constitutes a box (26).

4. Device according to any one of the preceding claims, characterized in that the pressure is afforded by a shape memory alloy (35) situated between a card (33) and the folded part (32) of the layer (31) linked to its neighbour card (33).

5. Device according to Claim 4, characterized in that the shape memory alloy (35) is traversed by a heating wire (36).

6. Device according to Claim 5, characterized in that the wire (36) is heated in order to retract the shape memory alloy (35) and allow the extraction of the card (33) held by it.

7. Device according to Claims 5 and 6, characterized in that a thermal insulator (37) is situated between the shape memory alloy (35) and a card (33) or a folded part (32) of a layer (31).

8. Device according to any one of the preceding claims, characterized in that the cards linked to the printed circuit have connection means distributed over their perimeter.

9. Device according to any one of the preceding claims, characterized in that at least one main connector (61) fixed to the printed circuit allows connection to other electronic systems.
